(19) Europäisches Patentamt
European Patent Office
Office européen des brevets

(11) EP 1 398 670 A2

(12) **EUROPEAN PATENT APPLICATION**

(43) Date of publication:
17.03.2004 Bulletin 2004/12

(51) Int Cl.7: **G03F 7/20**

(21) Application number: 03255700.1

(22) Date of filing: 11.09.2003

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: 13.09.2002 EP 02256420

(71) Applicant: ASML Netherlands B.V.
5503 LA Veldhoven (NL)

(72) Inventors:
• **Best, Keith Frank**
  **Prunedale, CA 93907 (US)**

• **Friz, Alexander**
  **San José, CA 95130 (US)**
• **Consolini, Joseph**
  **Costa Mesa, CA 92626 (US)**
• **Van Buel, Henricus Wilhelmus Maria**
  **5612 EE Eindhoven (NL)**

(74) Representative: **Leeming, John Gerard**
**J.A. Kemp & Co.,**
**14 South Square,**
**Gray's Inn**
**London WC1R 5JJ (GB)**

(54) **A method of aligning a substrate, a computer program and a device manufacturing method**

(57) While the alignment beam is focused on a mark on the substrate table the substrate table is moved substantially perpendicularly to the alignment beam. If the image of the mark moves relative to a reference mark, then the substrate and the alignment beam are not perpendicular. The mark on the substrate table is aligned to a plurality of reference marks. At least two substrate marks are then aligned with a single reference mark. Errors due to the inclination of the alignment beam are eliminated from the expansion and rotation values calculated for the substrate.

Fig. 5

EP 1 398 670 A2

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate having a mark;
- a projection system for projecting the patterned beam onto a target portion of the substrate; and
- an alignment system for detecting alignment between a reference mark and said mark using an alignment beam of radiation.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Before exposing the substrate it must be correctly aligned. A mark is therefore provided on the substrate table and an alignment beam is projected towards the mark and partially reflected through an alignment system. The alignment beam is imaged onto a reference mark to detect alignment between the mark and the reference mark.

For some applications, particularly Micro-Electromechanical Systems (MEMS), a pattern is transferred to a substrate, and a further substrate layer is then adhered onto the substrate, a "bonded wafer". In this situation, it is important for the patterns of two substrate layers to be correctly aligned relative to each other, and so the same alignment marks are used for both alignments and exposures. However, the patterns of the first and second substrate layers may still be misaligned. If the exposing beam of radiation is not exactly perpendicular to the substrate the difference in height between the first and second layers means that the surface of the layers intersect the alignment beam at different XY positions. The patterns on the two layers therefore wouldn't be correctly aligned. Furthermore, as the alignment marks may not be exactly in the focal plane of the alignment beam the alignment may be further compromised.

It is an object of the present invention to provide an improved method of aligning a substrate with reference marks.

This and other objects are achieved according to the invention in aligning a substrate to a plurality of reference marks comprising the steps of:

- providing said substrate with first and second substrate marks;
- providing an alignment beam;
- providing a substrate table for holding a substrate, said substrate table having a mark directly affixed thereto and being substantially perpendicular to said alignment beam;
- detecting the inclination of said alignment beam relative to said substrate table;
- adjusting said alignment beam to be perpendicular to said substrate table;
- aligning a first said reference mark with said mark on said substrate table using said alignment beam;
- aligning a second said reference mark with said mark on said table using said alignment beam;
- aligning said first reference mark with said first substrate mark using said alignment beam; and
- aligning said first reference mark with said second substrate mark using said alignment beam.

If the alignment beam is not exactly perpendicular to the substrate table the "vertical" (perpendicular to the surface of the substrate table) movement of the substrate table will generate a lateral movement of the mark with respect to the alignment beam. Ensuring that the alignment beam is perpendicular to the surface of the substrate thus alleviates this problem. Aligning the mark on the substrate table to the two reference marks ascertains the relative position of the reference marks and the substrate table. Aligning the substrate marks to a single reference mark ascertains the rotation and expansion of the substrate (relative to the reference marks known from earlier measurements). As the position of the two substrate marks is measured relative to a single reference mark there are no relative errors in the rotation and expansion values obtained. The substrate can be accurately aligned even if the substrate marks are not exactly in the focal plane of the alignment beam. The step of aligning the substrate marks to a reference mark can be repeated for further substrate marks, thereby calculating the rotation and expansion more accurately, possibly including some rotation or expansion elements which ere difficult to calculate using values from just two substrate marks. Using this method patterns on second and subsequent substrate layers can be aligned relative to a preceding layer with an accuracy better than 250 nm. This therefore allows bonded wafers with layers with a thickness up to 500 μm bonded to the preceding layer to be accurately aligned.

The step of detecting the inclination of said alignment beam relative to said substrate table comprises the steps of:

- detecting a first position of said mark on said substrate table relative to said alignment beam;
- moving said substrate table in a direction perpendicular to the top of said substrate table; and
- detecting a second position of said mark relative to said alignment beam

wherein the difference between said first and second relative positions indicates the inclination of the alignment beam relative to said substrate table.

Optionally there is a further step of aligning said second reference mark with said first substrate mark using said alignment beam. This provides a more accurate alignment of the substrate to the reference marks as the substrate is aligned to two different reference marks. This can be repeated for other reference marks, if there are any more.

The steps of aligning comprise projecting said alignment beam towards said mark or said substrate mark such that it is deflected through said reference mark.

The reference marks are preferably provided on a mask used to project a pattern onto the substrate. The substrate has a plurality of layers, the substrate marks being on a first layer visible through windows in a second layer.

The alignment beam is adjusted to be perpendicular to the substrate. Initially the inclination of the alignment beam relative to the substrate is detected and the alignment beam is consequently adjusted. The inclination of the alignment beam relative to the substrate is detecting by:

- detecting a first position of a (for example, the first) substrate mark relative to the alignment beam;

- moving said substrate in a direction perpendicular to the top of the substrate; and
- detecting a second position of the substrate mark relative to the alignment beam

wherein the difference between the first and second relative positions indicates the inclination of the alignment beam relative to the substrate.

The adjustment of the alignment beam to be perpendicular to the substrate takes place just prior to exposure taking place (i.e. after aligning the alignment beam to be perpendicular to the substrate). Alternatively it can take place just prior to the steps of aligning the reference marks with the substrate marks.

According to a further aspect of the invention there is a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material,

characterised by aligning said substrate by a method as described above.

According to a further aspect of the invention there is a computer program comprising program code means that, when executed on a computer system, instructs a lithographic projection apparatus to carry out the steps of an alignment method or a device manufacturing method as described above.

According to a further aspect of the invention there is provided a lithographic projection apparatus as specified in the opening paragraph wherein the substrate table can be moved in a direction substantially parallel to the alignment beam.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

> Figure 1 depicts a lithographic projection apparatus according to an embodiment of the invention;
> Figure 2 is a diagram showing the alignment mechanics;
> Figure 3 shows an alignment beam not perpendicular to the substrate;
> Figure 4 shows the alignment offset resulting from the set up of Figure 2;
> Figure 5 shows the movement of a substrate table according to the invention; and
> Figure 6 shows the steps involved in aligning a substrate with a set of reference marks; and
> Figure 7 shows a schematic cross section of a composite wafer used to assess the accuracy of the invention.

In the Figures, corresponding reference symbols indicate corresponding parts.

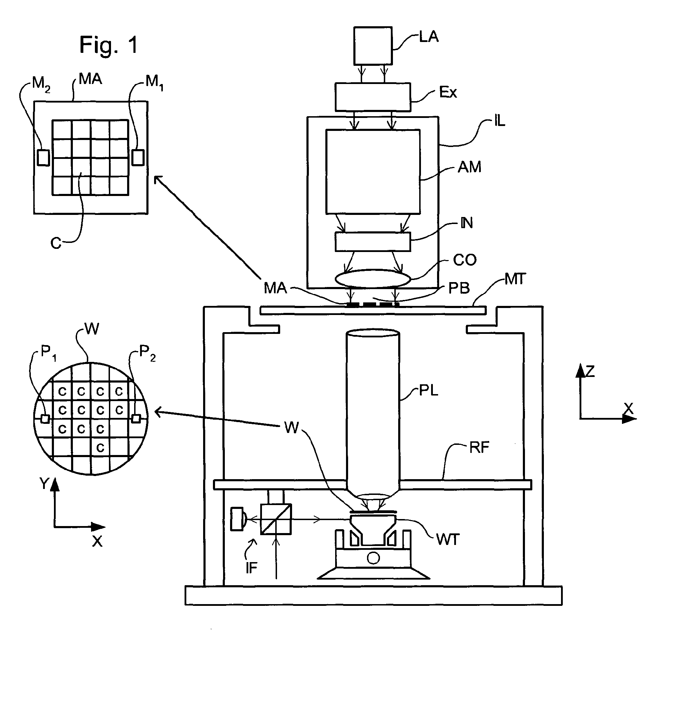

Figure 1 schematically depicts a lithographic projection apparatus according to a particular embodiment of the invention. The apparatus comprises:

- a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e. g.* a resist-coated silicon wafer), and connected to second positioning means for accurately positioning the substrate with respect to item PL;
- a projection system ("lens") PL (*e.g.* catadioptric lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fme positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

> 1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
> 2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target portion C can be exposed, without having to compromise on resolution.

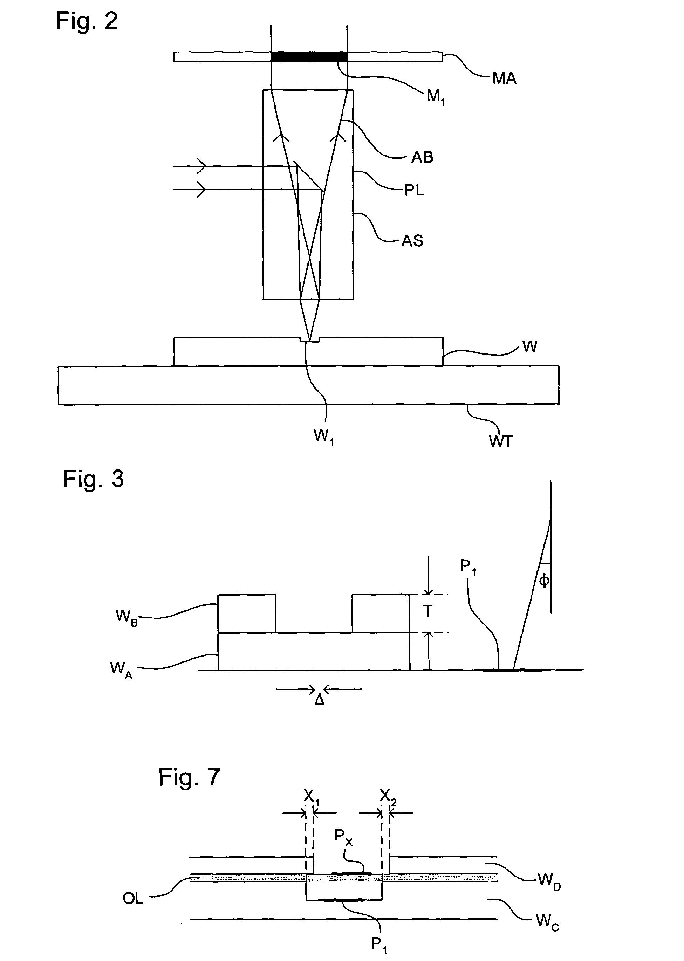

Prior to exposure of the substrate, alignment of the mask MA and the substrate W takes place. Complementary reference mark $M_1$ and mark $W_1$ are present on the mask MA and substrate table WT respectively. In Figure 2 an alignment beam AB is projected through the projection system PL and partially reflected from the mark $P_1$ through the alignment system AS. The alignment beam is then imaged onto the reference mark $M_1$. The alignment of the mark $W_1$ and reference mark $M_1$ can be detected to determine the alignment of the substrate W.

In Figure 3, the substrate consists of a first substrate layer $W_A$ and a second substrate layer $W_B$ of thickness T bonded to the top of first substrate layer $W_A$. Mark $P_1$ (sometimes called a fiducial), is situated on the substrate table WT adjacent to substrate W. As can be seen, the alignment beam AB is not perpendicular to the top surface of the substrate W. If projection onto the second substrate layer $W_B$ takes place with the alignment beam AB at this angle to the substrate W the measured position of the second substrate layer $W_B$ will differ from the real position of the second substrate layer $W_B$ by an offset $\Delta$, given by the equation:

$$\Delta = \phi.T$$

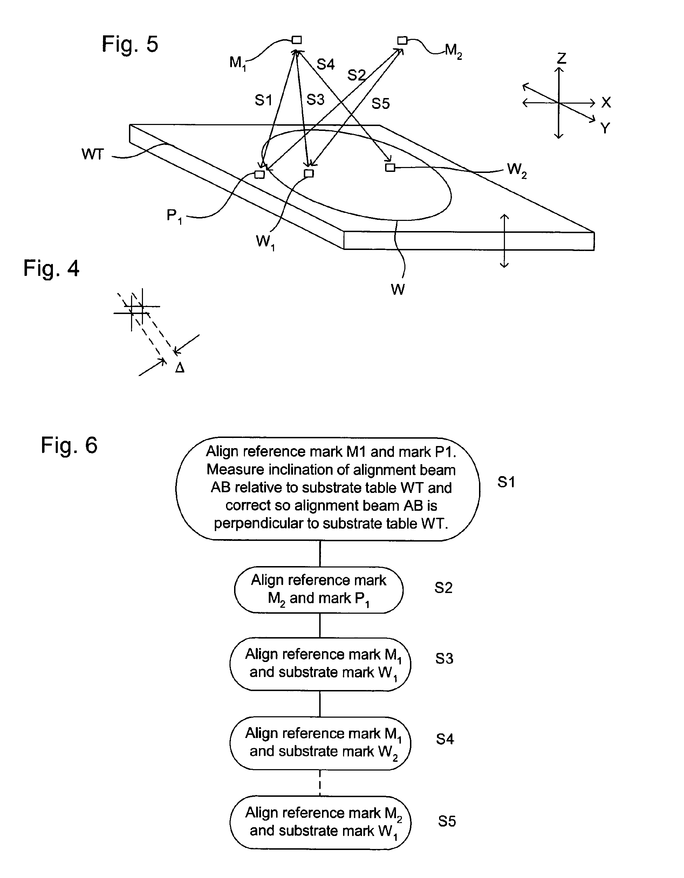

This can be seen in Figure 4. If printing on the second substrate layer $W_B$ occurs it will be offset from printing on the first substrate layer $W_A$ by an amount $\Delta$.

To detect this offset the substrate table WT is able to move vertically, as shown in Figure 5. To detect a misalignment of the alignment beam AB, the alignment beam is initially focused on mark $P_1$ and reflected towards reference mark $M_1$ in step S1. The substrate table WT is moved to establish correct XY orientation. The position of the image of mark $P_1$ relative to reference mark $M_1$ is scanned and the substrate table WT is then moved upwards in the Z direction by up to 100$\mu$m. The position of the image of mark $P_1$ relative to reference mark $M_1$ is scanned again and the results compared to the first scan. If the image of mark $P_1$ has moved relative to reference mark $M_1$ then the alignment beam AB and the substrate table WT are not perpendicular. The inclination of the alignment beam AB is therefore altered to correct this misalignment. The same procedure is repeated in order to check alignment again.

In step S2 the apparatus is adjusted so the alignment beam AB focuses on mark $P_1$ but is reflected towards a second reference mark $M_2$. This establishes the displacement of reference mark $M_2$ relative to $M_1$. The apparatus is adjusted again so the alignment beam AB focuses on substrate mark $W_1$ situated on the first substrate layer $W_A$ of substrate W and is reflected towards reference mark $M_1$ in step S3. As the alignment beam is perpendicular to the surface of the substrate W this establishes the relative positions of reference mark $M_1$ and substrate mark $W_1$ (and thus the absolute position of the substrate W). To determine the expansion and rotation of substrate W the apparatus is adjusted such that alignment beam AB is projected towards a second substrate mark $W_2$, also situated on the first substrate layer, and reflected towards first reference mark $M_1$. This is step S4. As the positions of $W_1$ and $W_2$ have both been measured with respect to the same reference mark $M_1$ any slight error (due to, for example, the substrate marks being slightly out of focus) will be the same for both measurements and the expansion and rotation values calculated will therefore be unaffected.

To obtain an improved calculation of the absolute position of the substrate W substrate mark $W_1$ is aligned with reference mark $M_2$ in step S5. The apparatus is adjusted so the alignment beam is projected towards substrate mark $W_1$ and reflected towards reference mark $M_2$.

Steps S3 and S4 can be repeated as necessary for further substrate marks. Step S5 can also be repeated for $W_2$ and further substrate marks. Similarly step S2 can be repeated for any additional marks on the substrate table WT. These additional steps all give improved accuracy of alignment.

This alignment process can be repeated for third and subsequent substrate layers, to a total thickness of 2 mm.

This procedure is preferably executed before any printing is done on any substrate layer.

To assess the accuracy of this method of detecting inclination a scanning electron microscope was used. The method described above was used to ensure that a substrate layer $W_c$ shown in Fig.7 and the alignment beam were perpendicular. A second substrate layer $W_D$ was adhered to the first substrate layer. The reference mark $M_1$, together with the perpendicular alignment beam were used to estimate the location of the $P_1$. At the estimated location of $P_1$, $P_x$ the second substrate layer is etched to the oxide layer, OL. A cross section of these alignment marks is then scanned using a SEM. The misalignment of the estimated location of $P_1$, and the action location of $P_1$ in the direction X is given by the equation:

$$X_T = \frac{(\Delta X_1 + \Delta X_2)}{2}$$

The cross section of the alignment marks must be scanned in at least two perpendicular directions in order to fully calculate the misalignment. Using this assessment technique the invention was shown to result in an overlay between original and estimated mark of <250nm over distances of up to 100 $\mu$m.

Whilst specific embodiments of the invention have been described above, it will be appreciated that the invention may be practiced otherwise than as described. The description is not intended to limit the invention.

## Claims

1. A method of aligning a substrate to a plurality of reference marks comprising the steps of:

   - providing said substrate with first and second substrate marks;
   - providing an alignment beam;
   - providing a substrate table for holding a substrate, said substrate table having a mark directly affixed thereto and being substantially perpendicular to said alignment beam;
   - detecting the inclination of said alignment beam relative to said substrate table;
   - adjusting said alignment beam to be perpendicular to said substrate table;
   - aligning a first said reference mark with said mark on said substrate table using said alignment beam;
   - aligning a second said reference mark with said mark on said table using said alignment beam;
   - aligning said first reference mark with said first substrate mark using said alignment beam; and
   - aligning said first reference mark with said second substrate mark using said alignment beam.

2. A method of aligning a substrate according to claim 1, wherein said step of detecting the inclination of said alignment beam relative to said substrate table comprises the steps of:

   - detecting a first position of said mark on said substrate table relative to said alignment beam;
   - moving said substrate table in a direction perpendicular to the top of said substrate table; and
   - detecting a second position of said mark relative to said alignment beam

   wherein the difference between said first and second relative positions indicates the inclination of the alignment beam relative to said substrate table.

3. A method of aligning a substrate according to either claim 1 or claim 2, further comprising a step of aligning said second reference mark with said first substrate mark using said alignment beam.

4. A method of aligning a substrate according to any one of the preceding claims, wherein said steps of aligning comprise projecting said alignment beam towards said mark or said substrate mark such that it is deflected through said reference mark.

5. A method of aligning a substrate according to any one of the preceding claims, further comprising the step of providing a mask on which said reference marks are arranged.

6. A method of aligning a substrate according to any one of the preceding claims, wherein said substrate has a plurality of layers, the substrate marks being on a first layer visible through windows in a second layer.

7. A method of aligning a substrate according to any one of the preceding claims wherein said alignment beam is adjusted to be perpendicular to said substrate.

8. A device manufacturing method comprising the steps of:

   - providing a substrate that is at least partially covered by a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material,

   **characterised by** aligning said substrate by a method according to any one of claims 1 to 6.

9. A computer program comprising program code means that, when executed on a computer system, instructs a lithographic projection apparatus to carry out the steps according to any one of claims 1 to 8.

Fig. 1

Fig. 2

Fig. 3

Fig. 7

Fig. 5

Fig. 4

Fig. 6

Align reference mark M1 and mark P1.
Measure inclination of alignment beam
AB relative to substrate table WT and
correct so alignment beam AB is
perpendicular to substrate table WT.

S1

Align reference mark
$M_2$ and mark $P_1$

S2

Align reference mark $M_1$
and substrate mark $W_1$

S3

Align reference mark $M_1$
and substrate mark $W_2$

S4

Align reference mark $M_2$
and substrate mark $W_1$

S5